# EUROPEAN PATENT SPECIFICATION

(11) **EP 2 808 423 B1**
(45) Date of publication and mention of the grant of the patent: **02.08.2017**
(21) Application number: 14001853.2
(22) Date of filing: 28.05.2014
(51) Int. Cl.: C23F 1/12, C23F 4/02, H01L 21/3213

(54) **Dry etching method**
Trockenätzverfahren
Procédé de gravure sèche

(30) Priority: 31.05.2013 JP 2013116250
(43) Date of publication of application: 03.12.2014
(73) Proprietor: Central Glass Company, Limited, Yamaguchi 755-0001 (JP)
(72) Inventor: Kikuchi, Akiou, Ube City Yamaguchi, 755-0001 (JP); Takeda, Yuta, Ube City Yamaguchi, 755-0001 (JP)
(74) Representative: dompatent von Kreisler Selting Werner - Partnerschaft von Patent- und Rechtsanwälten mbB

(56) References cited:
- JP-A- 2004 039 976
- JP-A- 2012 156 259
- VIGATO P A ET AL: "The evolution of beta-diketone or beta-diketophenol ligands and related complexes", COORDINATION CHEMISTRY REVIEWS, vol. 253, no. 7-8, April 2009 (2009-04), pages 1099-1201, XP026004375, ELSEVIER SCIENCE, AMSTERDAM [NL] ISSN: 0010-8545, DOI: 10.1016/J.CCR.2008.07.013 [retrieved on 2008-07-30]
- JAIN A ET AL: "Thermal dry-etching of copper using hydrogen peroxide and hexafluoroacetylacetone", THIN SOLID FILMS, ELSEVIER-SEQUOIA S.A. LAUSANNE, CH, vol. 269, no. 1, 15 November 1995 (1995-11-15), pages 51-56, XP004000578, ISSN: 0040-6090, DOI: 10.1016/0040-6090(95)06877-5
- FAHLMAN B. D., BARRON A. R: "Substituent Effects on the Volatility of Metal beta-diketonates", ADV. MATER. OPT. ELECTRON., vol. 10, no. 3-5, October 2000 (2000-10), pages 223-232, XP055214591, DOI: 10.1002/1099-0712(200005/10)10:3/5<223::AI D-AMO411>3.0.CO;2-M

## Description

### TECHNICAL FIELD

The present invention relates to a dry etching method performed on a metal film by use of etching gas containing β-diketone. Furthermore, herein described are a dry etching apparatus for realizing the method, a metal film etched by the method, and a device including the metal film.

### BACKGROUND ART

In a production process of a semiconductor device, a metal film is formed of a metal gate material, an electrode material or a magnetic material on a surface of a substrate by use of a film formation apparatus. In this film formation step, in addition to the metal film formed on the surface of the substrate, metal films or the like are unnecessarily attached to surfaces inside the film formation apparatus, for example, surfaces of a stage for holding and heating the substrate located in a film formation chamber of the film formation apparatus, surfaces of an electrode used to generate plasma, surfaces of other jigs, inner walls of the chamber, inner walls of tubes connected to the inner walls of the chamber, and the like. Such unnecessary metal films or the like need to be removed.

A known method for removing the unnecessary metal film or the like in the state where the chamber is still heated after the substrate having a film formed thereon is removed from the chamber is a dry cleaning method using β-diketone. According to an example of dry cleaning method, β-diketone such as, for example, hexafluoroacetylacetone (hereinafter, referred to simply as HFAc) is put into contact with a metal oxide film, and the metal oxide film is brought into a reaction and is removed in the form of a metal complex (for example, Patent Literature 1).

However, when this method is carried out on a metal film formed in a film formation chamber, an etching reaction does not proceed because the metal is not in an oxide state. According to another example of dry cleaning method for avoiding this, β-diketone such as HFAc or the like and oxygen are used in combination to oxidize the metal film. In this case, the metal oxide film is brought into a reaction and can be removed in the form of a metal complex (for example, Patent Literature 2 and Patent Literature 3).

In general, the process of etching a metal film by use of complexed gas such as β-diketone or the like can be divided into three reaction steps from the point of view of chemical reaction, namely, the step of oxidizing the metal film to generate a metal oxide (oxidation step), the step of complexing the metal oxide to form a metal complex (complexation step), and the step of sublimating the formed metal complex (sublimation step). Since an organic metal complex formed by a reaction with β-diketone has a high vapor pressure, unnecessary deposited substances containing the metal film can be easily removed along with the sublimation of the organic metal complex.

Patent Literature 4 discloses a method for processing a metal film formed at a surface of a processing target by use of a gas cluster beam. According to this method, mixed gas of oxide gas for oxidizing an element contained in a metal film to form an oxide, complexed gas that is reacted with an oxide to form an organic metal complex, and rare gas is adiabatically expanded to form a gas cluster beam; and the gas cluster beam is caused to impinge on the metal film of the processing target to etch the metal film. Patent Literature 4 also describes that oxide gas such as O₂, H₂O, H₂O₂ or the like is incorporated into the complexed gas used to form the organic metal complex.

Patent Literature 5 discloses an etching method including an etching step of etching a thin film formed on a substrate by use of etching gas containing β-diketone to expose a surface of the substrate. It is described that according to this method, H₂O is incorporated into the etching gas containing β-diketone such that H₂O has a concentration of 2000 ppm or less in order to increase the etching rate.

JP 2004-39976 A discloses a treating chamber 3 in which an insulating material is heated to have a temperature of 300 °C or more and 450 °C or below, while supplying thereto a cleaning gas, i.e. evaporated hexafluoroacetylacetone. When the cleaning gas supplied to the chamber is in touch with the insulating material stuck to the inner wall of the chamber or a susceptor, complexes of materials consisting the insulating material are formed. These complexes are easily evaporated due to the high steam pressure and discharged outside from the chamber owing to the exhaustion of the chamber.

Jain et al., Thin Solid Films 269 (1995), pages 51-56, describes oxidation of metal by H₂O₂, formation of Cu(hfac)₂ and production of H₂O in the reaction pathway.

### CITATION LIST

### PATENT LITERATURE

Patent Literature 1: Japanese Laid-Open Patent Publication No. 2001-176807
Patent Literature 2: Japanese Laid-Open Patent Publication No. Hei 6-101076
Patent Literature 3: Japanese Laid-Open Patent Publication No. Hei 11-140652
Patent Literature 4: Japanese Laid-Open Patent Publication No. 2012-156259
Patent Literature 5: Japanese Laid-Open Patent Publication No. 2004-91829

### SUMMARY OF INVENTION

The invention is set out in the appended claims. The embodiments of the description which do not fall within the scope of said claims are provided for illustrative purposes only and do not form part of the present invention.

### TECHNICAL PROBLEM

According to a known technology of metal etching, an oxidizer such as O₂, H₂O or the like is incorporated into complexed gas to proceed with an oxidation step, which is immediately followed by a complexation step and a sublimation step. In this manner, etching on the metal film proceeds (Patent Literature 2 and Patent Literature 3).

However, the structure of the complex to be formed varies in accordance with the type of metal to be etched. It has been found that with the conventional method, metal films of various structures are not necessarily etched equally. Especially, a metal material such as Co, Fe, Zn, Mn, Hf or the like, which forms a penta- or hexa-coordinated complex with β-diketone, does not allow a complexation reaction to proceed easily and thus does not provide a sufficiently high etching rate.

The present invention made in light of the above-described problem has an object of providing a dry etching method for etching, with increased etching rate, a film of a metal material that forms a penta- or hexa-coordinated complex structure with β-diketone. The present invention also has an object of providing a dry etching apparatus for realizing the method, a metal film etched by the method, and a device including the metal film.

### SOLUTION TO PROBLEM

Regarding etching on a metal film performed by use of β-diketone as complexed gas, the present inventors paid attention to a structure of a metal complex that forms a complex with β-diketone, and found that the etching reaction performed on a film of a metal that forms a penta- or hexa-coordinated complex structure with β-diketone is allowed to proceed in an improved manner by incorporating a certain amount of specific additive to β-diketone. Thus, the present invention has been made.

Namely, the present invention is directed to a dry etching method for etching a metal film formed on a substrate by use of etching gas containing β-diketone, wherein the metal film contains at least one metal material that forms a penta- or hexa-coordinated complex structure with β-diketone; the etching gas containing β-diketone contains at least one additive among H₂O or H₂O₂; and the additive is contained at a volume concentration of 1% or greater and 20% or less.

In the dry etching method, the metal film may be formed of at least one material selected from the group consisting of Zn, Co, Fe and Mn.

In the dry etching method, the etching gas is reacted with the metal film in a temperature range of 100°C or higher and 350°C or lower.

A dry etching apparatus is described including a chamber that accommodates a substrate having a metal film formed thereon, the metal film being formed of a metal material that forms a penta- or hexa-coordinated complex structure with β-diketone; an etching gas supply unit that is connected to the chamber and supplies etching gas containing β-diketone; an additive supply unit that is connected to the chamber and supplies at least one additive among H₂O and H₂O₂; and a heating unit that heats the chamber. The etching gas and the additive are supplied to the chamber such that the additive is contained at a volume concentration of 1% or greater and 20% or less.

In the dry etching apparatus, the metal film formed of at least one material selected from the group consisting of Zn, Co, Hf, Fe, Mn and V may be reacted with the etching gas.

In the dry etching apparatus, the heating unit may heat the chamber to a temperature of 100°C or higher and 350°C or lower; and the etching gas may be reacted with the metal film in the chamber.

A metal film is described, which is formed on a substrate and containing at least one metal material that forms a penta- or hexa-coordinated complex structure with β-diketone. The metal film has been etched with etching gas that contains β-diketone and also contains at least one additive among H₂O and H₂O₂ at a volume concentration of 1% or higher and 20% or lower.

The metal film may be formed of at least one material selected from the group consisting of Zn, Co, Hf, Fe, Mn and V is reacted with the etching gas.

The metal film may be a metal film which has been reacted with the etching gas in a temperature range of 100°C or higher and 350°C or lower.

It is furthermore provided a device including any metal film described above.

### ADVANTAGEOUS EFFECTS OF INVENTION

According to the present invention, the etching reaction performed on a film of a metal that forms a penta- or hexa-coordinated complex structure with β-diketone is allowed to proceed in an improved manner. A dry etching apparatus for realizing the method, a metal film etched by the method, and a device including the metal film are also provided.

### BRIEF DESCRIPTION OF DRAWINGS

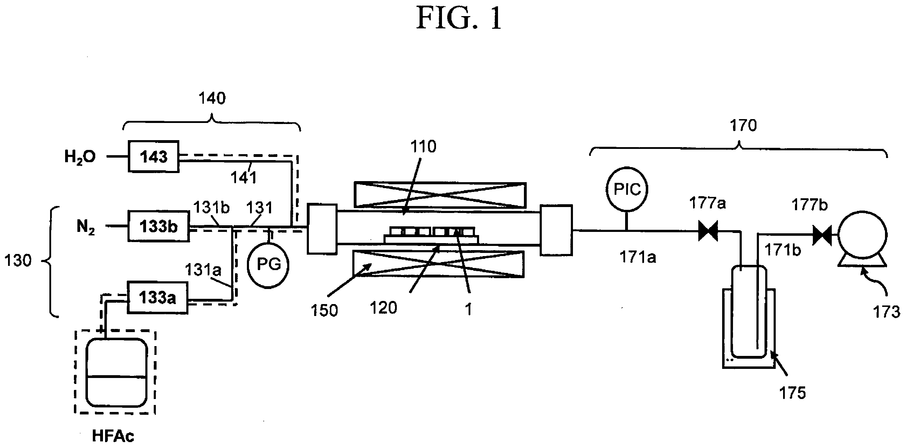

[FIG. 1] FIG. 1 is a schematic view of an etching apparatus.

### DESCRIPTION OF EMBODIMENTS

### (Method for etching a metal film)

The present invention is directed to a dry etching method for etching a metal film formed on a substrate by use of etching gas containing β-diketone. The metal film contains at least one metal material that forms a penta- or hexa-coordinated complex structure with β-diketone. The etching gas containing β-diketone contains at least one additive among H₂O and H₂O₂. The additive is contained at a volume concentration of 1% or greater and 20% or less.

According to the present invention, the etching gas is introduced into an etching apparatus that accommodates a processing target including a metal film, and the etching gas is put into contact with, and is reacted with, the metal film of the processing target to complex the metal film. Thus, the complexed metal film is etched. By incorporating a certain amount of specific additive into the etching gas, the etching rate on the metal film that forms a specific complex structure is increased.

A metal film, which is a target of the dry etching method according to the present invention, is formed of a material that forms a penta- or hexa-coordinated complex structure with β-diketone. Such a material is, insofar that it falls within the scope of present claim 1, at least one element selected from the group consisting of Zn, Co, Hf, Fe, Mn, V, Zr, Ti, Ru and Ir. The metal film may be formed of any one of these elements, or alternatively may be formed of a plurality of elements among these elements. For example, the metal film may be formed of a metal material such as NiSi, CoSi, HfSi, NiCo, FeCo, CoPt, MnZn, NiZn, CuZn, FeNi or the like or an oxide film thereof, insofar that it falls within the scope of present claim 1. The present invention is effective on a metal film containing at least one of Zn, Co, Fe and Mn among these elements. According to the present invention, the substrate may be any known etchable semiconductor substrate, glass substrate or the like on which a film of a material that forms a penta- or hexa-coordinated complex structure with β-diketone can be formed.

According to the present invention, the etching gas needs to contain β-diketone and H₂O or H₂O₂ as an additive. The present inventors were the first to find that the etching reaction performed on a film of a metal that forms a penta- or hexa-coordinated complex structure with β-diketone is allowed to proceed in an improved manner by incorporating a certain amount of H₂O or H₂O₂ as an additive. According to the present invention, as compared with the conventionally used condition that O₂ is incorporated, the concentration of H₂O is higher during the etching process. Therefore, the complexation rate is increased, and thus the etching rate is increased. Conventionally, H₂O is occasionally used as an oxidizer, but almost no example of using H₂O as a ligand for etching a metal film has been reported. A reason for this is that with the conventional art, O₂, which is used as an oxidizer, acts also as a ligand.

### (Discussion on complexation)

An etching reaction performed on a metal film by use of β-diketone mainly includes two steps, namely, an oxidation step and a complexation step. Now, in an example in which the metal film is formed of Co, the etching reaction is considered to include the following.
(1) Oxidation step

   2Co + O₂ → 2CoO
(2) Complexation step

   (a) CoO + 2HFAc → Co(HFAc)₂ + 2H₂O

   (b) Co(HFAc)₂ + 2H₂O → Co(HFAc)₂(H₂O)₂ ↑

Under the conventional condition that O₂ is incorporated, H₂O necessary for formation of a Co complex is merely supplied by generation in step (a), which is a part of the complexation step. Therefore, it is expected that among a series of reactions for etching a metal film by use of β-diketone, the complexation reaction is rate-controlling. According to the present invention, the metal in the metal film is oxidized by H₂O in the absence of oxidation gas (oxidation step). Two molecules of β-diketone are coordinated to the oxidized metal atom, and thus the metal forms a penta- or hexa-coordinated complex structure with β-diketone (complexation step (a)). H₂O molecule are coordinated at vacant coordination positions of the metal atom (H₂O gas acts as an oxidizer), and thus the complex is stabilized (complexation step (b)). It is considered that according to the present invention, such a reaction mechanism allows the metal in the metal film to be oxidized by H₂O even in the absence of the oxidation gas and thus the rate of the complexation reaction depends on the amount of H₂O.

Examples of β-diketone usable in the present invention include hexafluoroacetylacetone, trifluoroacetylacetone, acetylacetone and the like. One or a plurality of substances among these may be used. Hexafluoroacetylacetone and trifluoroacetylacetone, which allow etching to be performed at high speed, are especially preferable. As the concentration of β-diketone contained in the etching gas increases, the etching rate on the metal increases. It should be noted that in the case where the vapor pressure of β-diketone is low and there is a possibility that liquefaction is caused in the film formation apparatus, it is preferable to appropriately adjust the concentration by use of dilution gas.

The additive (H₂O or H₂O₂) contained in the etching gas has a content of 1% by volume or greater and 20% by volume or less in the etching gas composition. More preferably, the content of the additive in the etching gas is 3% by volume or greater and 10% by volume or less. When the content of the additive in the etching gas exceeds 20% by volume, β-diketone is undesirably hydrated. When the content of the additive in the etching gas is less than 1% by volume, the effect of the etching cannot be sufficiently provided.

The etching gas may contain, in addition to β-diketone and the additive (H₂O or H₂O₂), inert gas such as N₂, He, Ar, Ne, Kr or the like. In the case where inert gas is incorporated into the etching gas, there is no limitation on the concentration thereof as long as the inert gas is used as being diluted to an appropriate concentration. The inert gas is usually used at a content of 1% by volume or greater and 50% by volume or less, and is preferably used at a content of 30% by volume or greater and 50% by volume or less, with respect to the etching gas composition.

### (Dry etching apparatus)

The etching method according to the present invention can be realized by use of a common etching apparatus usable for a semiconductor production process as shown in FIG. 1. In an embodiment, an etching apparatus 100 includes, for example, a chamber 110 that accommodates a substrate 1, an etching gas supply unit 130 that is connected to the chamber 110 and supplies etching gas containing β-diketone, an additive supply unit 140 that is connected to the chamber 110 and supplies at least one additive among H₂O and H₂O₂, and a heating unit 150 that heats the chamber 110.

When H₂O or H₂O₂ is incorporated into β-diketone, β-diketone is hydrated and solidified. This may clog tubes. Therefore, the step of mixing β-diketone and H₂O or H₂O₂ in the etching apparatus 100 is preferably performed immediately before the etching gas is supplied to the chamber 110. However, from the point of view of fully mixing β-diketone and H₂O or H₂O₂, it is not preferable to incorporate β-diketone and H₂O or H₂O₂ separately. Therefore, the additive supply unit 140 is connected to the etching gas supply unit 130, so that β-diketone and H₂O or H₂O₂ are supplied to the chamber 110 in a mixed state.

The chamber 110 accommodates a stage 120 on which a substrate having a metal film, formed thereon, that forms a penta- or hexa-coordinated complex structure with β-diketone is to be placed. Any type of chamber that is resistant against β-diketone to be used and can have the inner pressure thereof decreased to a predetermined level may be usable as the chamber 110 with no specific limitation. Usually, a common chamber provided in a semiconductor etching apparatus, for example, is applied. A supply tube for supplying etching gas and other tubes may each be of any type that is resistant against β-diketone, with no specific limitation. A common tube is usable.

The etching gas supply unit 130 is connected to the chamber 110. The etching gas supply unit 130 supplies β-diketone to the chamber 110 via a tube 131. As shown in FIG. 1, a flow rate adjustment unit 133a adjusts the amount of β-diketone to be supplied, and thus β-diketone is supplied from a tube 131a to the tube 131. A flow rate adjustment unit 133b adjusts the amount of inert gas as dilution gas to be supplied, and thus the inert gas is supplied from the tube 131b to the tube 131. As described above, in this embodiment, the additive supply unit 140 adjusts the amount of at least one additive among H₂O or H₂O₂ to be supplied, and the additive is supplied from a tube 141 to the tube 131.

In the etching apparatus 100, β-diketone is diluted by the dilution gas to a predetermined concentration and is supplied to the chamber 100 in the state of being mixed at a predetermined concentration with the additive supplied from the additive supply unit 140. According to the present invention, β-diketone diluted immediately before being supplied to the chamber 110 and H₂O and/or H₂O₂ are mixed. Therefore, clogging of the tube 141, which would otherwise be caused by hydration and solidification of β-diketone, does not occur.

The heating unit 150 that heats the chamber 110 is located outside, and is connected to, the chamber 110. It is preferable that a heater as a second heating unit is provided inside the stage 120. In the case where a plurality of stages are located in the chamber 110, a heater may be provided for each of the stages so that each stage may be set to a predetermined temperature independently.

One end of the chamber 110 is connected to a gas discharge unit 170 that discharges post-reaction gas. The post-reaction gas is discharged from the chamber 110 by a vacuum pump 173 of the gas discharge unit 170 via a tube 171a. A liquid nitrogen trap 175 located between the tube 171a and a tube 171b recovers the post-reaction gas. The tubes 171a and 171b are provided with valves 177a and 177b so as to adjust the pressure. In FIG. 1, PG and PIC each represent a pressure meter. The flow rate adjustment units and the valves can be controlled based on values in PG and PIC.

The etching method will be specifically described. In the following description, the etching method is carried out by use of the etching apparatus 100. The substrate 1 having a metal film, formed thereon, that forms a penta- or hexa-coordinated complex structure with β-diketone is put into in the chamber 110. Inner pressures of the chamber 110, the tube 131, the tube 131a, the tube 131b, the liquid nitrogen trap 175, the tube 171a and the tube 171b are decreased to predetermined levels by vacuum replacement by use of the vacuum pump 173, and then the substrate 1 is heated by the heating unit 150. When the temperature in the chamber 110 reaches a predetermined level, β-diketone and dilution gas are supplied at a prescribed flow rate from the etching gas supply unit 130 to the tube 131, and the additive is supplied at a prescribed flow rate from the additive supply unit 140 to the tube 131.

The diluted β-diketone and the additive are mixed at a predetermined composition and supplied to the chamber 110. While the mixed etching gas is introduced into the chamber 110, the inner pressure of the chamber 110 is controlled to a predetermined level. The etching gas and the metal film are reacted with each other for a predetermined time period, and as a result, the metal film is etched.

After the etching, the heating by the heating unit 150 is stopped to decrease the temperature, and the vacuum pump 173 is stopped to release the chamber 110 from a vacuum state. In this manner, the etching on the metal film according to the present invention is performed.

In the etching method according to the present invention, the temperature of the metal film as a target of processing is in a range of 100°C or higher and 350°C or lower. There is no specific limitation on the inner pressure of the chamber during the etching. Usually, the inner pressure is in a range of 0.1 kPa to 101.3 kPa.

There is no specific limitation on the etching time period. It is preferable that the etching time period is 60 minutes or shorter in consideration of the efficiency of the semiconductor device production process. The "etching time period" refers to a time period from the time when the etching gas is introduced into the process chamber in which the substrate is located and an etching operation is to be performed until the etching gas in the process chamber is discharged by the vacuum pump or the like in order to terminate the etching operation.

The method described in Patent Literature 4, specifically, the method of etching a metal film by use of a cluster beam of complexed gas used to form an organic metal complex, is a non-plasma process and does not damage a sample electrically or by ultraviolet light. However, this method has a problem that the production of the apparatus is costly because a high pressure needs to be applied to the gas to be supplied in order to form a cluster beam, and a nozzle at the tip of the gas supply tube needs to be processed to have a specific shape. Regarding these points, the etching method according to the present invention does not require the etching apparatus to be significantly changed and thus is advantageous over the technology described in Patent Literature 4.

### (Etched metal film)

By use of the above-described etching method according to the present invention, a metal film can be provided that is formed on a substrate, contains at least one metal material that forms a penta- or hexa-coordinated complex structure with β-diketone, and is etched by use of etching gas containing β-diketone and also containing at least one of H₂O and H₂O₂ as an additive at a volume concentration of 1% or greater and 20% or less.

According to the present invention, a metal film is etched at significantly higher etching rate than by the conventional etching method, with no need to significantly change the etching apparatus. Therefore, the production cost of the etching apparatus is suppressed. As a result, the metal film can be produced at low cost.

### (Device)

The metal film may be used as a substitute of a metal film of a device produced by a conventional semiconductor production process. The device can be produced at low cost by using a metal film etched by the etching method according to the present invention. Examples of such a device include solar cell, hard disc drive, dynamic random access memory, phase change memory, ferromagnetic memory, magnetoresistive random access memory, resistive random access memory, MEMS and the like.

### (Examples)

Hereinafter, the present invention will be described in detail by way of examples. The present invention is not limited to the following examples. In etching tests performed on metal films, the relationship among the type of metal, the type of additive in the etching gas containing β-diketone, and the amount of additive was examined. The metal materials used were Co, Fe, Zn and Mn. In comparative examples, Ni was used as an example of metal material that forms a tetra-coordinated complex structure with β-diketone. As the additives (occasionally, referred to as "additive gas"), H₂O and H₂O₂ were used.

An etching apparatus like the etching apparatus 100 shown in FIG. 1 was used. As a sample, a metal foil (2 cm x 2 cm; thickness: 0.1 mm) formed on a substrate was used.

The inner pressures of the chamber 110, the tubes 131, 131a and 131b, the liquid nitrogen trap 175, and the tubes 171a and 171b were decreased to a level less than 10 Pa by vacuum replacement. Then, a sample placed on the stage 120 was heated to a predetermined temperature by the heating unit 150 and the heater located inside the heater 120. The weight of the sample had been measured in advance. After the temperature of the heating unit 150 and the heater located inside the stage 120 were confirmed to reach a predetermined value, β-diketone and dilution gas were supplied at a predetermined flow rate from the etching gas supply unit 130 to the tube 131, and an additive was supplied at a predetermined flow rate from the additive supply unit 140 to the tube 131. While the etching gas was introduced into the chamber 110, the inner pressure of the chamber 110 was controlled to a predetermined level. The introduction of the etching gas was stopped when a predetermined time period (10 minutes) elapsed after the start of the introduction. The inside of the chamber 110 was released from the vacuum state. Then, the sample was taken out, and the weight thereof was measured. Based on the difference between the pre-test weight and the post-test weight, the etched amount was calculated. In the examples, the lower limit of quantitative determination of the etched amount is 20 nm because of the measurement precision of the scale used to measure the weight.

In the etching tests of the examples, the total amount of the etching gas introduced into the chamber was 50 sccm, the dilution gas was N₂, and the etching time period was 10 minutes. Before performing the etching tests of the examples and the comparative examples, the inner pressure of the chamber and the temperature of the metal foil were each set to a predetermined level. Tables 1 through 5 show the etching conditions and the etched amounts of the metal materials in the examples and the comparative examples.

Hereinafter, experiment examples in which Co was etched as the target metal will be described. The results of etching Co are shown in Table 1.

**[Table 1]**

| | **Target metal** | **Gas composition (volume ratio)** | **Pressure (kPa)** | **Temperature (°C)** | **Etched amount (nm)** |
|---|---|---|---|---|---|
| **Ex. 1-1** | **Co** | **HFAc/H₂O/N₂ (50/1/49)** | **13.33** | **275** | **332.8** |
| **Ex. 1-2** | **Co** | **HFAc/H₂O/N₂ (50/2/48)** | **13.33** | **275** | **359.2** |
| **Ex. 1-3** | **Co** | **HFAc/H₂O/N₂ (50/5/45)** | **13.33** | **275** | **541.3** |
| **Ex. 1-4** | **Co** | **HFAc/H₂O₂/N₂ (50/5/45)** | **13.33** | **275** | **1042** |
| **Ex. 1-5** | **Co** | **HFAc/H₂O/N₂ (50/5/45)** | **13.33** | **150** | **105.2** |
| **Ex. 1-6** | **Co** | **HFAc/H₂O/N₂ (50/5/45)** | **1.33** | **275** | **224.2** |
| **Ex. 1-7** | **Co** | **TFAc/H₂O/N₂ (50/5/45)** | **13.33** | **275** | **378.1** |
| **Comparative ex. 1-1** | **Co** | **HFAc/H₂O/N₂ (50/30/20)** | **13.33** | **275** | **108** |
| **Comparative ex. 1-2** | **Co** | **HFAc/H₂O (50/50)** | **13.33** | **275** | **1.2** |
| **Comparative ex. 1-3** | **Co** | **HFAc/O₂/N₂ (50/3/47)** | **13.33** | **300** | **219.8** |
| **Comparative ex. 1-4** | **Co** | **HFAc/O₂/N₂ (50/5/45)** | **13.33** | **300** | **122.4** |
| **Comparative ex. 1-5** | **Co** | **HFAc/O₂/N₂ (50/10/40)** | **13.33** | **300** | **185.2** |
| **Comparative ex. 1-6** | **Co** | **HFAc/O₂/N₂ (50/30/20)** | **13.33** | **275** | **160.9** |
| **Comparative ex. 1-7** | **Co** | **HFAc/N₂ (50/50)** | **13.33** | **275** | **55.4** |
| **Comparative ex. 1-8** | **Co** | **HFAc/O₂/N₂ (50/5/45)** | **13.33** | **150** | **13.2** |
| **Comparative ex. 1-9** | **Co** | **HFAc/O₂/N₂ (50/5/45)** | **1.33** | **275** | **34.7** |

### [Example 1-1] - [Example 1-3]

Etching tests of examples 1-1, example 1-2 and example 1-3 were performed, in which H₂O was used as the additive gas and the volume concentrations of H₂O were 1%, 2% and 5%, respectively. In the etching tests, the inner pressure of the chamber was 13.33 kPa, and the temperature of the metal foil was 275°C. The etched amounts in examples 1-1, 1-2 and 1-3 were 332.8 nm, 359.2 nm and 541.3 nm, respectively.

### [Example 1-4]

An etching test of example 1-4 was performed under the same experimental conditions as those of example 1-1 except that H₂O₂ was used as the additive gas. The etched amount of Co was 1042 nm.

### [Example 1-5] - [Example 1-7]

The pressure, the temperature or the like at the time of etching may be restricted depending on the type of etching apparatus. Therefore, etching performed under the following conditions was also examined: the temperature of the metal foil: 150°C (example 1-5); the inner pressure of the chamber: 1.33 kPa (example 1-6); and β-diketone: trifluoroacetylacetone (example 1-7). The other experimental conditions were the same as those of example 1-3. Example 1-5 was compared against comparative example 1-8 described later, and example 1-6 was compared against comparative example 1-9 described later. The etched amounts in both of the examples were superior to those in the comparative examples. Namely, even in the case where the temperature of the metal foil was 150°C and the inner pressure of the chamber was 1.33 kPa, an effect of significantly increasing the etched amount was provided by using H₂O as the additive. In the case where trifluoroacetylacetone was used as β-diketone also, the etched amount was equivalent to that in example 1-3.

### [Comparative example 1-1] - [Comparative example 1-2]

Etching tests of comparative examples 1-1 and comparative example 1-2 were performed, in which the volume concentrations of H₂O as the additive gas were 30% and 50% respectively, the temperature of the metal foil was 275°C, and the inner pressure of the chamber was 13.33 kPa. The etched amounts in comparative examples 1-1 and 1-2 were 108 nm and 1.2 nm, respectively. In the case where the volume concentration of the additive was outside the range of the present invention, the etched amounts were inferior to those in examples 1-1 through 1-3 even though the temperature and pressure conditions were the same as those of these examples.

### [Comparative example 1-3] - [Comparative example 1-6]

Etching tests of comparative example 1-3, comparative example 1-4, comparative example 1-5 and comparative example 1-6 were performed, in which oxygen was used as the additive gas and the volume concentration of oxygen was varied in the range of 3% to 30%. In comparative examples 1-3 through 1-6, the etched amount was changed as the volume concentration of oxygen was changed. The etching amounts were superior to that in the case where no additive was incorporated (comparative example 1-7), but were inferior to those in the examples in which H₂O or H₂O₂ was incorporated as the additive even though the same temperature and pressure conditions were the same as those of these examples.

### [Comparative example 1-7]

An etching test of comparative example 1-7 was performed under the same experimental conditions as those of example 1-1 except that no additive was incorporated. The etched amount in comparative example 1-7 was 55.4 nm.

### [Comparative example 1-8]

An etching test of comparative example 1-8 was performed under the same experimental conditions as those of example 1-5 except that O₂ was used as the additive gas. The etched amount in comparative example 1-8 was 13.2 nm. The temperature of the metal foil was 150°C, which was lower than in the other comparative examples, and the etched amount was inferior to that in comparative example 1-7 in which no additive was incorporated. As compared against example 1-5 performed under the same temperature and pressure conditions but with a different additive, the etched amount was inferior.

### [Comparative example 1-9]

An etching test of comparative example 1-9 was performed under the same experimental conditions as those of example 1-6 except that O₂ was used as the additive gas. The etched amount in comparative example 1-9 was 34.7 nm. As compared against example 1-6 performed under the same temperature and pressure conditions but with a different additive, the etched amount was inferior.

Now, experiment examples in which Fe was etched as the target metal will be described. The results of etching Fe are shown in Table 2.

**[Table 2]**

| | **Target metal** | **Gas composition (volume ratio)** | **Pressure (kPa)** | **Temperature (°C)** | **Etched amount (nm)** |
|---|---|---|---|---|---|
| **Ex. 2-1** | **Fe** | **HFAc/H₂O/N₂ (50/2/48)** | **13.33** | **275** | **317.9** |
| **Ex. 2-2** | **Fe** | **HFAc/H₂O/N₂ (50/5/45)** | **13.33** | **275** | **1525.6** |
| **Ex. 2-3** | **Fe** | **HFAc/H₂O/N₂ (50/8/42)** | **13.33** | **275** | **628.2** |
| **Ex. 2-4** | **Fe** | **HFAc/H₂O₂/N₂ (50/5/45)** | **13.33** | **275** | **2031.2** |
| **Ex. 2-5** | **Fe** | **HFAc/H₂O/N₂ (50/5/45)** | **13.33** | **150** | **351.2** |
| **Ex. 2-6** | **Fe** | **HFAc/H₂O/N₂ (50/5/45)** | **1.33** | **275** | **181.4** |
| **Ex. 2-7** | **Fe** | **TFAc/H₂O/N₂ (50/5/45)** | **13.33** | **275** | **1068.3** |
| **Comparative ex. 2-1** | **Fe** | **HFAc/H₂O/N₂ (50/30/20)** | **13.33** | **275** | **69.2** |
| **Comparative ex. 2-2** | **Fe** | **HFAc/H₂O (50/50)** | **13.33** | **275** | **ND(-40)** |
| **Comparative ex. 2-3** | **Fe** | **HFAc/O₂/N₂ (50/2/48)** | **13.33** | **275** | **193.2** |
| **Comparative ex. 2-4** | **Fe** | **HFAc/O₂/N₂ (50/3/47)** | **13.33** | **275** | **234.6** |
| **Comparative ex. 2-5** | **Fe** | **HFAc/O₂/N₂ (50/5/45)** | **13.33** | **275** | **75.6** |
| **Comparative ex. 2-6** | **Fe** | **HFAc/O₂/N₂ (50/5/45)** | **13.33** | **150** | **103.5** |
| **Comparative ex. 2-7** | **Fe** | **HFAc/O₂/N₂ (50/5/45)** | **1.33** | **275** | **130.6** |

### [Example 2-1] - [Example 2-3]

Etching tests of examples 2-1, example 2-2 and example 2-3 were performed, in which H₂O was used as the additive gas and the volume concentrations of H₂O were 2%, 5% and 8%, respectively. In the etching tests of examples 2-1 through 2-3, the inner pressure of the chamber was 13.33 kPa, and the temperature of the metal foil was 275°C. The etched amounts in examples 2-1, 2-2 and 2-3 were 317.9 nm, 1525.6 nm, 628.2 nm, respectively.

### [Example 2-4]

An etching test of example 2-4 was performed under the same experimental conditions as those of example 2-1 except that H₂O₂ was used as the additive gas. The etched amount in example 2-4 was 2031.2 nm.

### [Example 2-5] - [Example 2-7]

Etching tests were performed under the same experimental conditions as those of example 2-2 except that the temperature of the metal foil was 150°C (example 2-5), the inner pressure of the chamber was 1.33 kPa (example 2-6), and β-diketone was trifluoroacetylacetone (example 2-7). Example 2-5 was compared against comparative example 2-7 described later, and example 2-6 was compared against comparative example 2-8 described later. The etched amounts in both of the examples were superior to those in the comparative examples. Namely, even in the case where the temperature of the metal foil was 150°C and the inner pressure of the chamber was 1.33 kPa, an effect of significantly increasing the etched amount was provided by using H₂O as the additive. In the case where trifluoroacetylacetone was used as β-diketone also, the etched amount was equivalent to that in example 2-2.

### [Comparative example 2-1] - [Comparative example 2-2]

Etching tests of comparative examples 2-1 and comparative example 2-2 were performed, in which the volume concentrations of H₂O as the additive gas were 30% and 50% respectively, the temperature of the metal foil was 275°C, and the inner pressure of the chamber was 13.33 kPa. The etched amounts in comparative examples 2-1 and 2-2 were 69.2 nm and equal to or lower than the detection limit (ND), respectively. In the case where the volume concentration of the additive was outside the range of the present invention, the etched amounts were inferior to those in examples 2-1 through 2-3 even though the temperature and pressure conditions were the same as those of these examples.

### [Comparative example 2-3] - [Comparative example 2-5]

Etching tests of comparative example 2-3, comparative example 2-4 and comparative example 2-5 were performed, in which oxygen was used as the additive gas and the volume concentration of oxygen was varied in the range of 2% to 5%. In comparative examples 2-3, 2-4 and 2-5, the etched amount was changed as the volume concentration of oxygen was changed. The etching amounts in comparative examples 2-3 through 2-5 were inferior to those in the examples in which H₂O₂ was incorporated as the additive even though the temperature and pressure conditions were the same as those of these examples.

### [Comparative example 2-6]

An etching test of comparative example 2-6 was performed under the same experimental conditions as those of example 2-5 except that O₂ was used as the additive gas. The etched amount in comparative example 2-6 was 103.5 nm. As compared against example 2-5 performed under the same temperature and pressure conditions but with a different additive, the etched amount was inferior.

### [Comparative example 2-7]

An etching test of comparative example 2-7 was performed under the same experimental conditions as those of example 2-6 except that O₂ was used as the additive gas. The etched amount in comparative example 2-7 was 130.6 nm. As compared against example 2-6 performed under the same temperature and pressure conditions but with a different additive, the etched amount was inferior.

Now, experiment examples in which Zn was etched as the target metal will be described. The results of etching Zn are shown in Table 3.

**[Table 3]**

| | **Target metal** | **Gas composition (volume ratio)** | **Pressure (kPa)** | **Temperature (°C)** | **Etched amount (nm)** |
|---|---|---|---|---|---|
| **Ex. 3-1** | **Zn** | **HFAc/H₂O/N₂ (50/2/48)** | **24** | **275** | **391.8** |
| **Ex. 3-2** | **Zn** | **HFAc/H₂O/N₂ (50/5/45)** | **24** | **275** | **1248** |
| **Ex. 3-3** | **Zn** | **HFAc/H₂O₂/N₂ (50/5/45)** | **24** | **275** | **1532** |
| **Ex. 3-4** | **Zn** | **HFAc/H₂O/N₂ (50/5/45)** | **24** | **150** | **341.7** |
| **Ex. 3-5** | **Zn** | **HFAc/H₂O/N₂ (50/5/45)** | **1.33** | **275** | **217.2** |
| **Ex. 3-6** | **Zn** | **TFAc/H₂O/N₂ (50/5145)** | **24** | **275** | **998.4** |
| **Comparative ex. 3-1** | **Zn** | **HFAc/H₂O/N₂ (50/30/20)** | **24** | **275** | **20.6** |
| **Comparative ex. 3-2** | **Zn** | **HFAc/O₂/N₂ (50/2/48)** | **24** | **275** | **136.5** |

### [Example 3-1] - [Example 3-2]

Etching tests of examples 3-1 and example 3-2 were performed, in which H₂O was used as the additive gas and the volume concentrations of H₂O were 2% and 5%, respectively. In the etching tests of examples 3-1 and 3-2, the inner pressure of the chamber was 13.33 kPa, and the temperature of the metal foil was 275°C. The etched amounts in examples 3-1 and 3-2 were 319.8 nm and 1248 nm, respectively.

### [Example 3-3]

An etching test of example 3-3 was performed under the same experimental conditions as those of example 3-1 except that H₂O₂ was used as the additive gas. The etched amount in example 3-3 was 1532 nm.

### [Example 3-4] - [Example 3-6]

Etching tests were performed under the same experimental conditions as those of example 3-1 except that the temperature of the metal foil was 150°C (example 3-4), the inner pressure of the chamber was 1.33 kPa (example 3-5), and β-diketone was trifluoroacetylacetone (example 3-6). Even in the case where the temperature of the metal foil was 150°C and the inner pressure of the chamber was 1.33 kPa, the etched amounts were equivalent to that in example 3-1. In the case where trifluoroacetylacetone was used as β-diketone also, the etched amount was equivalent to that in example 3-2.

### [Comparative example 3-1]

An etching test of comparative examples 3-1 was performed, in which the volume concentration of H₂O as the additive gas was 30%, the temperature of the metal foil was 275°C, and the inner pressure of the chamber was 13.33 kPa. The etched amount in comparative examples 3-1 was 20.6 nm. In the case where the volume concentration of the additive was outside the range of the present invention, the etched amount was inferior to those in examples 3-1 and 3-2 even though the temperature and pressure conditions were the same as those of these examples.

### [Comparative example 3-2]

An etching test of comparative example 3-2 was performed, in which oxygen was used as the additive gas and the volume concentration of oxygen was 2%. The etching amount in comparative example 3-2 was 136.5 nm. As compared against the example in which H₂O or H₂O₂ was incorporated as the additive, the etched amount in comparative example 3-2 was inferior.

Now, experiment examples in which Mn was etched as the target metal will be described. The results of etching Mn are shown in Table 4.

**[Table 4]**

| | **Target metal** | **Gas composition (volume ratio)** | **Pressure (kPa)** | **Temperature (°C)** | **Etched amount (nm)** |
|---|---|---|---|---|---|
| **Ex. 4-1** | **Mn** | **HFAc/H₂O/N₂ (50/2/48)** | **13.33** | **275** | **233.1** |
| **Ex. 4-2** | **Mn** | **HFAc/H₂O/N₂ (50/5/45)** | **13.33** | **275** | **491.3** |
| **Ex. 4-3** | **Mn** | **HFAc/H₂O₂/N₂ (50/5/45)** | **13.33** | **275** | **589.7** |
| **Ex. 4-4** | **Mn** | **HFAc/H₂O/N₂ (50/5/45)** | **13.33** | **150** | **98.1** |
| **Ex. 4-5** | **Mn** | **HFAc/H₂O/N₂ (50/5/45)** | **1.33** | **275** | **184.9** |
| **Ex. 4-6** | **Mn** | **TFAc/H₂O/N₂ (50/5/45)** | **13.33** | **275** | **397.9** |
| **Comparative ex. 4-1** | **Mn** | **HFAc/H₂O/N₂ (50/30/20)** | **13.33** | **275** | **13.9** |
| **Comparative ex. 4-2** | **Mn** | **HFAc/O₂/N₂ (50/2/48)** | **13.33** | **275** | **81.8** |
| **Comparative ex. 4-3** | **Mn** | **HFAc/O₂/N₂ (50/5/45)** | **13.33** | **150** | **10.4** |

### [Example 4-1] - [Example 4-2]

Etching tests of examples 4-1 and example 4-2 were performed, in which H₂O was used as the additive gas and the volume concentrations of H₂O were 2% and 5%, respectively. In the etching tests of examples 4-1 and 4-2, the inner pressure of the chamber was 13.33 kPa, and the temperature of the metal foil was 275°C. The etched amounts in examples 4-1 and 4-2 were 233.1 nm and 491.3 nm, respectively.

### [Example 4-3]

An etching test of example 4-3 was performed under the same experimental conditions as those of example 4-1 except that H₂O₂ was used as the additive gas. The etched amount in example 4-3 was 589.7 nm.

### [Example 4-4] - [Example 4-6]

Etching tests were performed under the same experimental conditions as those of example 4-1 except that the temperature of the metal foil was 150°C (example 4-4), the inner pressure of the chamber was 1.33 kPa (example 4-5), and β-diketone was trifluoroacetylacetone (example 4-6). Example 4-4 was compared against comparative example 4-3 described later. Even in the case where the temperature of the metal foil was 150°C, the etched amount was superior to that in the comparative example. Even in the case where the inner pressure of the chamber was 1.33 kPa, the etched amount was equivalent to that in example 4-1. Even in the case where trifluoroacetylacetone was used as β-diketone, the etched amount was equivalent to that in example 4-2.

### [Comparative example 4-1]

An etching test of comparative examples 4-1 was performed, in which the volume concentration of H₂O as the additive gas was 30%, the temperature of the metal foil was 275°C, and the inner pressure of the chamber was 13.33 kPa. The etched amount in comparative examples 4-1 was 13.9 nm. In the case where the volume concentration of the additive was outside the range of the present invention, the etched amount was inferior to those in examples 4-1 and 4-2.

### [Comparative example 4-2]

An etching test of comparative example 4-2 was performed, in which oxygen was used as the additive gas and the volume concentration of oxygen was 2%. The etching amount in comparative example 4-2 was 81.8 nm. As compared with the examples in which H₂O or H₂O₂ was incorporated as the additive, the etched amount in comparative example 4-2 was inferior.

### [Comparative example 4-3]

An etching test of comparative example 4-3 was performed under the same experimental conditions as those of example 4-4 except that O₂ was used as the additive gas. The etched amount in comparative example 4-3 was 10.4 nm. As compared against example 4-4 performed under the same temperature and pressure conditions but with a different additive, the etched amount was inferior.

Now, experiment examples in which Ni, which forms a tetra-coordinated complex structure with β-diketone, was etched as the target metal will be described. The results of etching Ni are shown in Table 5.

**[Table 5]**

| | **Target metal** | **Gas composition (volume ratio)** | **Pressure (kPa)** | **Temperature (°C)** | **Etched amount (nm)** |
|---|---|---|---|---|---|
| **Comparative ex. 5-1** | **Ni** | **HFAc/H₂O/N₂ (50/2/48)** | **13.33** | **250** | **613.0** |
| **Comparative ex. 5-2** | **Ni** | **HFAc/H₂O/N₂ (50/5/45)** | **13.33** | **325** | **956.2** |
| **Comparative ex. 5-3** | **Ni** | **HFAc/H₂O₂/N₂ (50/5/45)** | **13.33** | **325** | **947.8** |
| **Comparative ex. 5-4** | **Ni** | **HFAc/O₂/N₂ (50/2/48)** | **13.33** | **250** | **902.1** |

### [Comparative example 5-1] - [Comparative example 5-2]

Etching tests of comparative examples 5-1 and example 5-2 were performed, in which H₂O was used as the additive gas and the volume concentrations of H₂O were 2% and 5%, respectively. In the etching tests of comparative examples 5-1 and 5-2, the inner pressure of the chamber was 13.33 kPa and the temperature of the metal foil was 250°C and 325°C, respectively. The etched amounts in comparative examples 5-1 and 5-2 were 613.0 nm and 956.2 nm, respectively.

### [Comparative example 5-3]

An etching test of comparative example 5-3 was performed under the same experimental conditions as those of comparative example 5-2 except that H₂O₂ was used as the additive gas. The etching amount in comparative example 5-3 was 947.8 nm.

### [Comparative example 5-4]

An etching test of comparative example 5-4 was performed, in which O₂ was used as the additive gas and the volume concentration of O₂ was 2%. In the etching test of comparative example 5-4, the inner pressure of the chamber was 13.33 kPa and the temperature of the metal foil was 250°C. The etched amount in comparative example 5-4 was 902.1 nm.

From the results of comparative examples 5-1 through 5-4, it is seen that the effect of incorporating H₂O was not provided for Ni, which forms a tetra-coordinated complex structure with β-diketone.

### REFERENCE SIGNS LIST

1: substrate; 110: chamber; 130: etching gas supply unit; 131: tube; 131a: tube; 131b: tube; 133a: flow rate adjustment unit; 133b: flow rate adjustment unit; 140: additive supply unit; 141: tube; 143: flow rate adjustment unit; 150: heating unit; 170: gas discharge unit; 171a: tube; 171b: tube; 173: vacuum pump; 175: liquid nitrogen trap: 177a: valve; 177b: valve.

### INDUSTRIAL APPLICABILITY

The present invention is useful for microprocessing performed by etching on a metal film in semiconductor device production.

## Claims

1. A dry etching method for etching a metal or metal oxide film containing metal includes at least one material selected from the group consisting of Zn, Co, Fe and Mn formed on a substrate by use of etching gas containing β-diketone, wherein:
the etching gas containing β-diketone contains at least one additive among H₂O or H₂O₂; and
the additive is contained at a volume concentration of 1% or greater and 20% or less,
wherein the etching gas is reacted with the film containing the metal or the metal oxide in a temperature range of 100°C or higher and 350°C or lower,
the metal material in the film is oxidized by H₂O or H₂O₂,
two molecules of β-diketone are coordinated to the oxidized metal atom and H₂O molecule are coordinated at vacant coordination positions of the metal atom, and
the metal material forms a penta- or hexa-coordinated complex structure with two molecules of β-diketone and H₂O.

## Patentansprüche

1. Trockenätzverfahren zum Ätzen eines Metall- oder Metalloxidfilms, der ein Metall, das wenigstens ein Material umfasst, welches aus der Gruppe ausgewählt ist, die aus Zn, Co, Fe und Mn besteht, enthält und auf einem Substrat gebildet ist, unter Verwendung eines Ätzgases, das ein β-Diketon enthält, wobei:
das Ätzgas, das ein β-Diketon enthält, wenigstens ein Additiv aus H₂O oder H₂O₂ enthält; und
das Additiv in einer Volumenkonzentration von 1% oder mehr und 20% oder weniger enthalten ist;
wobei das Ätzgas in einem Temperaturbereich von 100 °C oder mehr und 350 °C oder weniger mit dem Film, der das Metall oder das Metalloxid enthält, umgesetzt wird;
das Metallmaterial in dem Film durch H₂O oder H₂O₂ oxidiert wird;
zwei Moleküle β-Diketon an dem oxidierten Metallatom koordiniert sind und H₂O-Moleküle an den freien Koordinationsstellen des Metallatoms koordiniert sind; und
das Metallmaterial eine penta- oder hexakoordinierte Komplexstruktur mit zwei Molekülen β-Diketon und H₂O bildet.

## Revendications

1. Procédé de gravure sèche pour la gravure d'un film de métal ou d'oxyde de métal contenant un métal comprenant au moins un matériau choisi dans le groupe consistant en Zn, Co, Fe et Mn, formé sur un substrat, en utilisant un gaz de gravure contenant une β-dicétone, dans lequel :
ledit gaz de gravure contenant une β-dicétone contient au moins un additif parmi H₂O ou H₂O₂, et
ledit additif est contenu dans une concentration volumique de 1 % ou plus et 20 % ou moins,
dans lequel l'on fait réagir ledit gaz de gravure avec le film contenant le métal ou l'oxyde de métal dans une plage de température allant de 100 °C ou plus à 350 °C ou moins,
le matériau métallique dans le film est oxydé par du H₂O ou par du H₂O₂,
deux molécules de β-dicétone sont coordinées à l'atome métallique oxydé, et des molécules H₂O sont coordinées à des positions de coordination vacantes de l'atome métallique, et
le matériau métallique forme une structure complexe penta- ou hexacoordinée avec deux molécules de β-dicétone et H₂O.
